(19) Europäisches Patentamt
European Patent Office
Office européen des brevets

(11) **EP 3 355 626 B1**

(12) **EUROPEAN PATENT SPECIFICATION**

(45) Date of publication and mention
of the grant of the patent:
**29.09.2021  Bulletin 2021/39**

(51) Int Cl.:
*H04W 52/02* *(2009.01)*    *H03L 1/02* *(2006.01)*

(21) Application number: **18153817.4**

(22) Date of filing: **29.01.2018**

(54) **METHOD AND APPARATUS FOR DIGITAL QUARTZ TEMPERATURE AND DRIFT COMPENSATION FOR A SLEEP TIMER OF A NB-IOT DEVICE**

VERFAHREN UND VORRICHTUNG ZUR DIGITALEN QUARZTEMPERATUR- UND DRIFTKOMPENSATION FÜR EINEN SCHLAF-TIMER EINER NB-IOT-VORRICHTUNG

PROCÉDÉ ET APPAREIL DE COMPENSATION DE TEMPÉRATURE ET DE DÉRIVE D'UN QUARTZ NUMÉRIQUE POUR UN TEMPORISATEUR DE VEILLE D'UN DISPOSITIF NB-IDO

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.01.2017  EP 17153667**

(43) Date of publication of application:
**01.08.2018  Bulletin 2018/31**

(73) Proprietor: **SHENZHEN GOODIX TECHNOLOGY CO., LTD.**
**Shenzhen, Guangdong 518045 (CN)**

(72) Inventor: **Hesse, Kay**
**01129 Dresden (DE)**

(74) Representative: **Lippert Stachow Patentanwälte Rechtsanwälte**
**Partnerschaft mbB**
**Krenkelstraße 3**
**01309 Dresden (DE)**

(56) References cited:
**EP-A1- 2 297 627    US-A- 4 922 212**
**US-B1- 6 473 607**

**Description**

The invention relates to a method for digital quartz temperature and drift compensation for a sleep timer of a NB-IoT device.

The invention also relates to an apparatus for digital quartz temperature and drift compensation for a sleep timer of a NB-IoT device.

NarrowBand Internet-of-things (NB-IoT) devices are rather new. These devices are typically connected to an IoT network (Internet of Things) and will be used/produced cheap and in high quantities.

Many IoT devices cannot be accessed physically once they were put into operation. These are e.g. sensors in street grounds, animals or at other not easily accessible places. Protecting and saving battery power of these devices is important because the battery cannot be recharged or replaced. Furthermore, these devices wake-up only for a short time for sending or providing data to the network, but most of the time these devices are in a sleep mode. For some applications it is important that the NB-IoT devices provide and send their data at specified points in time and hence it is important to guarantee that these devices wake up at these specific and specified times. Therefore, NarrowBand Internet-of-Things (NB-IoT) devices comprise a sleep timer with a quartz crystal in order to wake up after long deep sleep periods and to send the required data. US 6,473,607 B1 discloses a dual mode timer that extends battery life. In WO 2010/002330 A1 an electronic timer system with a translator for translating between raw base time and local precise time using a look-up table is disclosed and in US 4,922,212 an oscillator temperature compensation circuit using stored and calculated values of a look-up table is disclosed for compensating frequency variations of a crystal.

For IoT applications normally X-cut crystals are used for a 32 kHz sleep timer of a NB-IoT device.

It is known that X-cut crystals typically have a parabolic dependency on temperature, where the offset shows a characteristic like

$$\frac{\Delta f}{f} = c_T \cdot (T - T_0)^2 + d_0 \; \rightarrow \; d_f = c_T \cdot \Delta T^2 + d_0 \quad \texttt{(eq. 1)},$$

where $C_T$ is the temperature coefficient of the quartz crystal in the range of for example -0.025ppm ...-0.05ppm/K$^2$ and the so-called "turnover temperature" $T_0$ is in the range of for example 20...30°C. The do term describes a pseudo-static frequency offset (initial offset plus potential drift contribution), which is in the order of $\pm 10\%$ of the temperature offset. The Temperature T is considered to be in the range of for example -55 ...+125°C (extended industrial range).

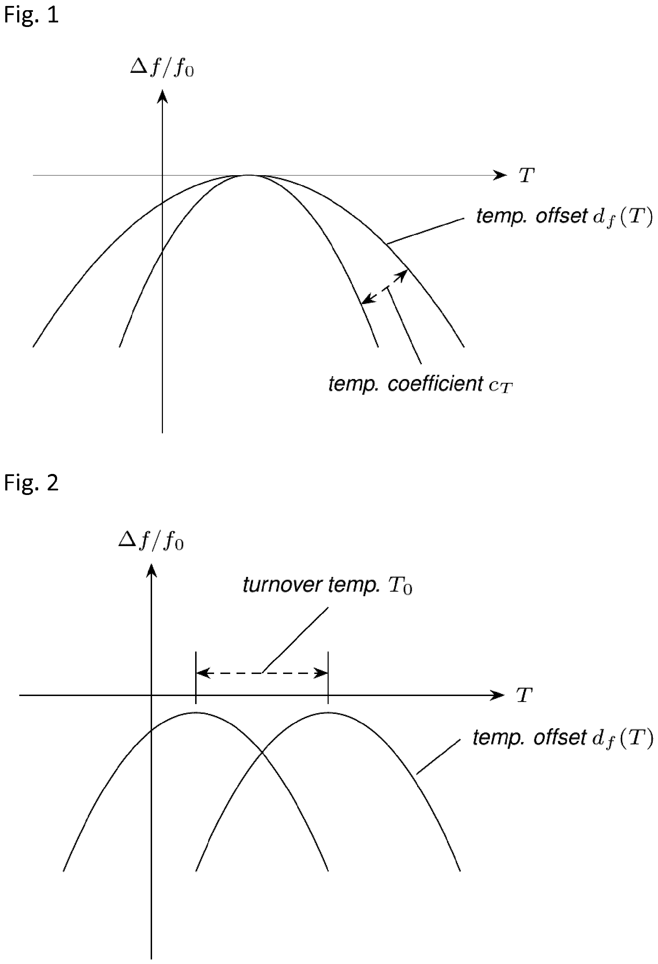

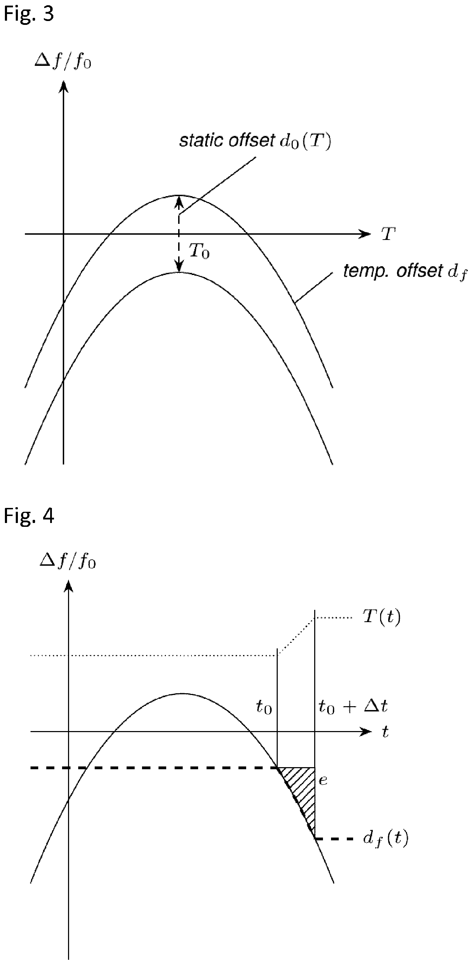

Figure 1 shows the influence of the temperature coefficient $C_T$ on the quartz frequency offset $d_f$. Figure 2 shows the influence of the turnover temperature To on the quartz frequency offset, whereas the turnover temperature is understood as the temperature at which the tangent to the parabola is parallel to the x-axis. And figure 3 shows the influence of static offset do on the quartz frequency offset.

Until now, the compensation of quartz temperature and drift compensation in temperature measurement setups was performed analogue, either with a quartz crystal with a controlled heating or as a "pull-circuit" for the quartz frequency.

For NarrowBand Internet-of-Things (NB-IoT) devices it is absolutely disadvantageous to use quartz crystals with a power consuming heating in order to compensate drifts due to the temperature dependence of the quartz crystal of the sleep timer.

It is therefore the objective of the invention to provide a method and an apparatus which allow exploiting the known characteristic of typically used quartz oscillators in such NB-IoT devices in order to compensate temperature and drift of the quartz crystal frequency due to temperature and to make the device cheaper, less power consuming and more flexible. Generally, it is desirable to find a way for an effective quartz crystal temperature and drift compensation in NB-IoT devices.

The objective of the invention will be solved by a method for digital temperature and drift compensation of a quartz crystal from its nominal frequency for a sleep timer used for a NarrowBand Internet of Things (NB-IoT) according to claim 1.

Before other preferred and advantageous embodiments of the inventive method are described, the theory of operation of such quartz crystals used for the sleep timer of a NB-IoT device and its temperature dependence are considered.

It is known that static offset as well as dynamic offset contributors have to be considered to be able to compensate their influences in NB-IoT devices, which use quartz crystals in a sleep timer for counting and determine its active and idle periods.

Static offset contributors are considered first. In general, the measured temperature T, as well as the quartz crystal parameters $C_T$ and do are inaccurate to some extent. The propagation of uncertainty caused by their individual uncertainties to the overall uncertainty $d_f$ can be estimated using the variance formula:

$$\Delta d_f^2 = \sqrt{(\frac{\delta d_f}{\delta T}\Delta T)^2 + (\frac{\delta d_f}{\delta c_T}\Delta c_T)^2 + (\frac{\delta d_f}{\delta d_0}\Delta d_0)^2} \quad (\text{eq. } 2)$$

Looking at each contributor separately allows the following simplifications:

$$|\Delta d_f(T)| = \left|\frac{\delta d_f}{\delta T}\Delta T\right| = |-2c_T(T - T_0)\Delta T| \quad (\text{eq. } 3)$$

$$|\Delta d_f(c_T)| = \left|\frac{\delta d_f}{\delta c_T}\Delta c_T\right| = |(T - T_0)\Delta c_T| \quad (\text{eq. } 4)$$

$$|\Delta d_f(d_0)| = \left|\frac{\delta d_f}{\delta d_0}\Delta d_0\right| = |\Delta d_0| \quad (\text{eq. } 5)$$

It is possible to determine the maximum uncertainty budget for each parameter (temperature T, temperature coefficient $C_T$, and pseudo-static frequency offset do) of the quartz crystal. According to a global error range, for example 0.5ppm, that will be defined first, the individual contribution from each parameter can be calculated and considered in the hardware design of the NB-IoT device.

In order to assess the overall quartz temperature and drift compensation, dynamic offset contributors have to be considered as well.

The frequency offset $d_f$ calculated according to equation (eq. 1) describes the momentary deviation at a given point in time. When integrated over a certain interval, the number of missing/excessive clock pulses during that interval can be obtained by:

$$P(\Delta t) = \int_{t_0}^{t_0+\Delta t} d_f dt \quad (\text{eq. } 6).$$

So far, all calculations regarding uncertainties and resolutions were done under the assumption of a static, yet uncertainly measured temperature and static quartz crystal parameters. In reality, though, temperature is a function of time, most simply modeled as linear dependency:

$$\text{T} = \text{T(t)} = \text{g}_\text{T} \cdot \text{t} + \text{T}_\text{s} \quad (\text{eq. } 7).$$

Inserting equation (eq. 7) into equation (eq. 1) then yields:

$$d_f(t) = c_T \cdot (g_T \cdot t + T_s - T_0)^2 + d_0 = c_T \cdot (g_T \cdot t + T_c)^2 + d_0 \quad (\text{eq. } 8).$$

So, while the temperature is changing and sampled only at certain intervals $\Delta t$, a frequency offset is accumulated. This is depicted in figure 4, which uses equation (eq. 8) as temporal temperature dependence. Figure 4 shows the dependence of the frequency offset $d_f(t)$ (dashed graph) from the temperature (dotted graph), which is assumed to change linearly with time within the interval to ... $t_0+\Delta t$. The solid line shows the quartz frequency offset as a function of time. The accumulated error corresponds to the shaded region in figure 4 and is the bigger, the greater the sampling interval and the steeper the temperature gradient at that point of the curve. Frequency offset during intervals of constant temperature ($t < t_0$ or $t > t_0+\Delta t$) can be fully compensated, so these constant contributions do not add to the sampling error e. Hence:

$$e = P_{real} - P_{approx} = \left( \int_{t_0}^{t_0+\Delta t} d_f(t)dt \right) -$$

$$\Delta t \cdot d_f(t_0) = \left( \int_{t_0}^{t_0+\Delta t} (c_T \cdot (g_T \cdot t + T_c)^2 + d_0)dt \right) - \Delta t \cdot (c_T \cdot (g_T \cdot t_0 + T_c)^2 + d_0$$

(eq. 9).

Resolving the integral will then lead to:

$$e = \left[ \frac{1}{3} c_T (g_T \cdot t + T_c)^3 \cdot \frac{1}{g_T} + d_0 \cdot t \right]\Big|_{t_0}^{t_0+\Delta t} - \Delta t \cdot (c_T \cdot (g_T \cdot t_0 + T_c)^2 + d_0) =$$

$$\left[ \frac{c_T}{3g_T} \cdot (g_T \cdot t + T_c)^3 + d_0 \cdot (t_0 + \Delta t) \right] - \left[ \frac{c_T}{3g_T} \cdot (g_T \cdot t_0 + T_c)^3 + d_0 \cdot t_0 \right] - \Delta t \cdot$$

$$(c_T \cdot (g_T \cdot t_0 + T_c)^2 + d_0) \quad (eq. 10).$$

After various transformation this eventually yields:

$$e = c_T (g_T^2 t_0 \Delta t^2 + g_T^2 \Delta t^3 + g_T \Delta t^2 T_c \quad (eq. 11).$$

The error calculated according to equation (eq. 11) basically describes the offset made when compensation is only done with the values calculated at exactly the sample times without any interpolation. In other words, the integral $P_{real}$ to the offset-over-time curve is approximated by a sequence of rectangles. However, a better approximation is achieved by a piecewise trapezoid shape which yields:

$$P_{approx} = \frac{1}{2} \Delta t c_T [(g_T(t_0 + \Delta t) + T_c)^2 + d_0 + (g_T t_0 + T_c)^2] + d_0 l = c \left[ (g_T^2 t_0^2 \Delta t + \right.$$

$$g_T^2 t_0 \Delta t^2 + \frac{1}{2} g_T^2 \Delta t^3 + 2g_T t_0 \Delta t T_c + g_T \Delta t^2 T_c + \Delta t T_c^2 \right] + d_0 \Delta t \quad (eq. 12).$$

Replacing now the term for $P_{approx}$ in equation (eq. 9) with the new approximation from equation (eq. 12) then yields:

$$e_a = \frac{1}{2} c_T g_T^2 \Delta t^3 \quad (eq. 13).$$

This remaining (in-compensable) error would be accrued in each sampling interval as long as the temperature is changing. For a worst-case estimation a linear temperature change within the full operational range $\Delta T_{max}$ is considered. The duration of this full-range change depends on the thermal gradient $g_T$:

$$D = \frac{\Delta T_{max}}{g_T} \quad (eq. 14)$$

and the number of sampling intervals therefor is:

$$n_s = \frac{D}{\Delta t} \quad (eq. 15).$$

Hence, the total accrued error for this full-range temperature sweep is the product of the number of steps and the in-compensable error per step as given in equation (eq. 13):

$$\boldsymbol{e_{tot}} = \boldsymbol{n_s} \cdot \boldsymbol{e_r} = \frac{D}{\Delta t} \cdot \frac{1}{2} c_T g_T^2 \Delta t^3 = \frac{1}{2} D c_T g_T^2 \Delta t^2 \quad (\text{eq. 16}).$$

For a constant temperature, the permissible offset of a defined global error range, for example 0.5ppm, from the static contributors would accumulate a total offset of

$$\text{e}_{tot,stat} = 0.5 * \text{D} \quad (\text{eq. 17}).$$

Now assuming that the total temporal offset according to equation (eq. 16) shall not exceed the static contribution following the relation can be derived:

$$\frac{1}{2} D c_T g_T^2 \Delta t^2 \leq 0.5 \cdot D \quad (\text{eq. 18})$$

which then translates to:

$$\Delta t \leq \sqrt{\frac{1}{c_T g_T^2}} = \frac{1}{g_T} \sqrt{\frac{1}{c_T}} \quad (\text{eq. 19}).$$

So, the sampling interval $\Delta t$ should be chosen inverse proportionally to the assumed or measured temperature gradient $g_T$.

Depending on all the offset contributions described above, the real frequency may be either too slow or too fast with respect to the nominal frequency. Since the real frequency drives the sleep timer counter, this means that the counter value accumulated over a given interval is off by a number of ticks, and this value is either too low or too high. As described above it is possible to determine the frequency offset d(T) as a function of mainly the measured temperature T. With this knowledge it becomes possible to compensate the counter bias of the sleep timer. Basically:

$$C_T = f_T \cdot \Delta t = \left(f_0 + d_f\right) \cdot \Delta t = C_{norm} + C_{offs} \quad (\text{eq. 20}).$$

In order to compensate the bias, it is necessary to add/subtract $C_{offs}$ ticks during the interval $\Delta t$. This is achieved by providing a clock $d_c$ derived from the offset clock $f_T$ like this:

$$d_c = f_T \cdot \frac{|d_f|}{f_0 + d_f} \quad (\text{eq. 21})$$

so that

$$C_{comp} = d_c \cdot \Delta t \quad (\text{eq. 22})$$

and hence

$$C_T = \left(f_0 + d_f\right) \cdot \Delta t + \begin{cases} d_c \cdot \Delta t & for \ d_f < 0 \\ -d_c \cdot \Delta t & for \ d_f \geq 0 \end{cases} = \left(f_0 + d_f\right) \cdot \Delta t + \left(f_0 + d_f\right) \cdot \Delta t \cdot$$

$$\begin{cases} \frac{-d_f}{f_0 + d_f} for \ d_f < 0 \\ \frac{d_f}{f_0 + d_f} for \ d_f \geq 0 \end{cases} = C_{norm} + C_{offs} + \begin{cases} C_{nom} \ for \ d_f < 0 \\ -C_{nom} \ for \ d_f \geq 0 \end{cases} = C_{nom} \quad (\text{eq. 23}).$$

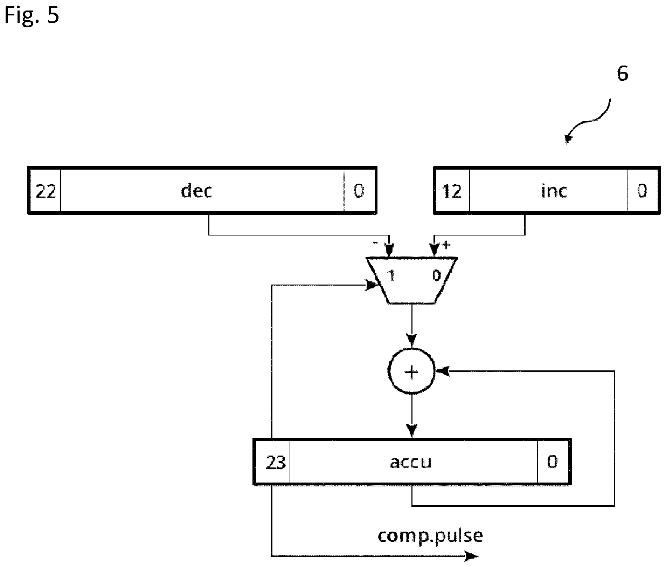

Equation (eq. 21) may seem tautological, but it reflects the fact that although the frequency offset $d_f$ is known the only clock that can be used for counting is the temperature-influenced quartz clock of the sleep timer. Therefore, a fractional divider according to figure 5 is used and allows generating exactly this:

$$f_d = f \cdot \frac{inc}{dec+inc} \quad \text{(eq. 24).}$$

Combining equation (eq. 21) and equation (eq. 24) then yields:

$$inc = |d_f| \quad \text{(eq. 25)}$$

and

$$dec = \begin{cases} f_0 & for \ d_f \geq 0 \\ f_0 + 2d_f & for \ d_f < 0 \end{cases} \quad \text{(eq. 26).}$$

After the derivation of the theory underlying the inventive method it is preferred in one embodiment that the temperature is acquired at fixed temperature sampling intervals. This is the simplest form of the inventive method and best suited for environments with mostly stable temperatures, because only a static frequency offset has to be compensated.

In another preferred embodiment of the inventive method, the temperature is acquired at adaptive temperature sampling intervals. This means that the temperature sampling interval is dynamically re-selected at each new sampling point to minimize the in-compensable error caused mostly by temperature fluctuations during the sampling intervals. In practical scenarios the parameters used to determine the next sampling interval (temperature differences, offsets) have less resolution than otherwise used for these types of data. This is the case to save power and area in implementation without sacrificing the ability to control the interval selection.

In a further embodiment of the inventive method, the temperature sampling interval is selected based on up to four temperature ranges. This will be done by specifying three limits given as absolute differences from the turnover temperature $T_0$ of the used quartz crystal of the sleep timer. The effective number of ranges can be decreased by specifying identical values for the limits, e.g. when setting two limits to the same value the number of ranges is decreased to three instead of four. The ranges defined by the temperature difference limits should be chosen according to the derivative and/or the result of equation (eq. 1). The range around the turnover temperature To can be made wider because both the absolute result (and hence the offset to be compensated) is low as well as the susceptibility to temperature changes, so the overall in-compensable error is limited. More outer ranges should therefore be smaller.

In another embodiment of the inventive method, the temperature sampling interval is selected based on a temperature difference between a previous and a current sampling point. This will be used when operating in an environment with dynamic temperature changes or high temperature gradients and has the advantage of a good balance between frequency of measurement which also consumes some power and accuracy of compensation.

In another embodiment of the inventive method, the temperature sampling interval is selected based on a predicted offset for compensation at a time of the previous temperature measurement and a calculated offset of the previous interval determined at a current measurement, multiplied with a length of the previous sampling interval. This leads in a residual offset which needs to be backward compensated at the beginning of the next sampling interval. This will be used when again there is a high variance in temperature fluctuation and has the advantage of minimizing the amount of post-compensation at each new sampling time.

In a further embodiment of the inventive method, the temperature sampling interval is selected based on temperature difference between a previous and a current sampling point and a predicted offset for compensation at a time of the previous temperature measurement and a calculated offset of the previous interval determined at a current measurement, multiplied with a length of the previous sampling interval. This is a combination of the embodiments of the inventive method claimed according to claims 5 and 6. This will be used when there is a more unknown thermal environment and has the advantage if providing good compensation under arbitrary conditions.

And in another further embodiment of the inventive method, the external reference is a radio cell the NB-IoT is communicating with. This has a great advantage, because the clock of the radio cell is very accurate, and hence it is preferred to use the clock of the radio cell to adjust the clock of the sleep timer of the NB-IoT device during its active periods in order to compensate quartz temperature and drifts during the much longer sleep periods.

The advantage of the inventive method can be seen therein, that the method provides a possibility to compensate drift characteristic of the quartz crystal due to its temperature dependence. As in sleeping periods of the NB-IoT device only the pulses of the quartz crystal are available, only the quartz frequency can be used as reference. By compensating the quartz frequency according to the known behavior any drift and deviation can be compensated and corrected. In the active phase the NB-IoT can get a reference time indication from the connected radio cell. It is possible to determine the quartz crystal frequency against the frequency of the radio cell in order to get the true difference value. With this knowledge the curvature and displacement of the quartz crystal frequency can be adjusted.

The object of the invention will also be solved by an apparatus for digital quartz temperature and drift compensation of a sleep timer of a NarrowBand Internet of Things (NB-IoT) device according to claim 7. The apparatus comprises a temperature sensor connected to a temperature acquisition block, an offset calculation block connected to an internal storage block and the temperature acquisition block for calculating and determining an offset of a quartz frequency of the quartz crystal for the sleep timer due to its temperature dependence based on measured temperature values by the temperature sensor, whereas the sleep timer (11) is connected to the apparatus for digital quartz temperature and drift compensation, the apparatus further comprising an adjustment generator providing tuning pulses for the sleep timer of the NB-IoT device in a sleep phase according to the measured and determined temperature dependence of the frequency offset of the sleep timer, whereas the adjustment generator is connected to the offset calculation block and a controlling finite state machine (FSM), and the FSM controls the temperature acquisition block, the internal storage block and the adjustment generator.

The quartz temperature and drift compensation (QTDC) is responsible to equalize deviations of for example a 32 kHz crystal of a sleep timer from its nominal frequency, based on acquired temperature measurements and information on the frequency offset. The adjustment generator then generates compensation pulses for the sleep timer, whereas the pulses are used there to adjust the counter value of the sleep timer.

The finite state machine is used to control the compensation process. It determines the sampling interval based on register settings, acquires the temperature and controls the generation of compensation impulses.

In an embodiment of the inventive apparatus for digital quartz temperature and drift compensation for a sleep timer of a NarrowBand Internet of Things (NB-IoT) device, the adjustment generator is a fractional divider. A fractional divider also called a clock divider or scaler or prescaler, is a circuit that takes an input signal of a frequency, $f_{in}$, and generates an output signal of a frequency: $f_{out} = f_{in} * m/n$, where m and n are integers. The fractional divider provides the tuning pulses for the sleep timer of the NB-IoT device in a sleep phase according to the measured and determined temperature dependence of the frequency offset of the sleep timer. In comparison to already known NB-IoT devices with no possibility of quartz temperature and drift compensation this has the advantage that the device can stay longer in a low-power deep sleep mode, since the wake-up time can be set more closely to the actual time when the device needs to be operative. It is no longer necessary to add a big safety margin to the wake-up time to compensate for frequency uncertainty.

In another embodiment of the inventive apparatus, the temperature sensor comprises a digital interface. This has the advantage of using off-the-shelf sensors that are widely available with e.g. I2C or SPI interfaces.

The invention will be explained in more detail using exemplary embodiments.

The appended drawings show

Fig. 1     The influence of the temperature coefficient $C_T$ on the quartz frequency offset;

Fig. 2     The influence of the turnover temperature $T_0$ on the quartz frequency offset;

Fig. 3     The influence of static offset $d_0$ on the quartz frequency offset;

Fig. 4     The influence of temperature sample interval $\Delta t$ on quartz frequency offset;

Fig. 5     A Fractional divider;

Fig. 6     Workflow of the inventive method;

Fig. 7     Inventive apparatus for digital quartz temperature and drift compensation of a sleep timer of a NB-IoT device.

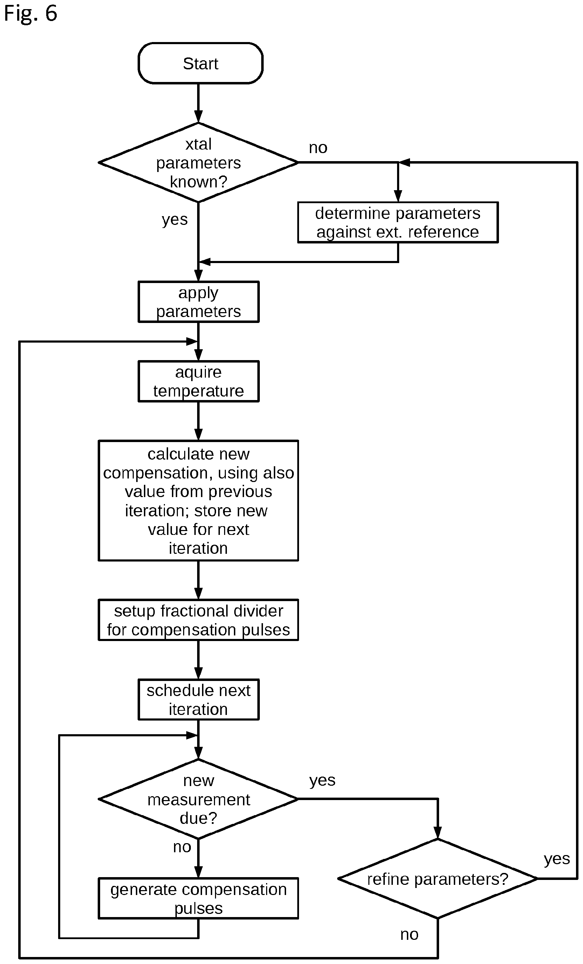

Figure 6 shows the workflow of the inventive method for digital temperature and drift compensation of a quartz crystal from its nominal frequency used for a sleep timer of a NarrowBand Internet of Things (NB-IoT) device. In a first step it will be decided if the quartz crystal parameters of the quartz crystal used for the sleep timer are known. If these parameters are not known, the parameters have to be determined by measuring separately. But this is not advantageous for mass production devices. The parameters can also be determined against an external reference, like a connected radio cell as mentioned earlier.

If the quartz crystal parameters are known or have been determined and stored for further processing, a temperature measured by a temperature sensor is acquired. With the acquired temperature a deviation of the quartz crystal frequency offset due to its temperature dependence and the measured temperature is determined and compensation pulses for the quartz crystal of the sleep timer according to the deviation of the quartz crystal frequency offset are calculated in order to adjust a counter value of the sleep timer of the NB-IoT device. Therefore, a fractional divider is used in order to generate pluses with a frequency that is a fraction of the reference clock, hence the clock of the quartz crystal for the sleep timer or the time indication of a radio cell to which the NB-IoT device is connected to.

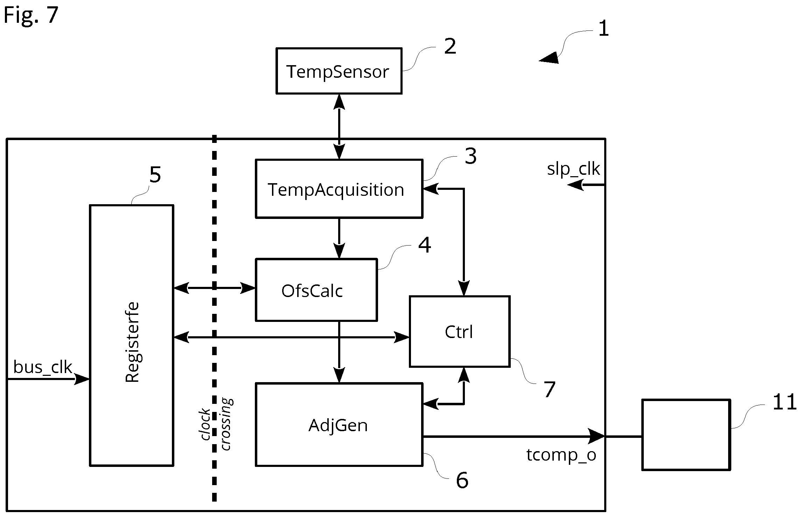

Figure 7 shows an exemplary setup of the inventive apparatus for digital quartz temperature and drift compensation of a sleep timer 11 of a NB-IoT device 1. The apparatus comprises a temperature sensor 2 connected to a temperature acquisition block 3, an offset calculation block 4 connected to an internal storage block 5 and the temperature acquisition block 3 for calculating and determining an offset of a quartz frequency of the sleep timer 11 due to its temperature dependence based on measured temperature values by the temperature sensor 2, an fractional divider 6 providing tuning pulses for the sleep timer 11 of the NB-IoT device 1 in a sleep phase according to the measured and determined temperature dependence of the frequency offset of the sleep timer 11. The fractional divider 6 is connected to the offset calculation block 4 and a controlling finite state machine (FSM) 7, and the FSM 7 controls the temperature acquisition block 3, the internal storage block 5 and the adjustment generator 6.

### List of Reference Signs

| | |
|---|---|
| 1 | Digital quartz temperature and drift compensation of a NB-IoT device |
| 2 | temperature sensor |
| 3 | temperature acquisition block |
| 4 | offset calculation block |
| 5 | internal storage block |
| 6 | adjustment generator, e.g. a fractional divider |
| 7 | finite state machine (FSM) 7 |
| 11 | sleep timer |

### Claims

**1.**   A method for digital temperature and drift compensation of a quartz crystal with a parabolic dependency on temperature from its nominal frequency for a sleep timer (11) used for a NarrowBand Internet of Things (NB-IoT) device, the method comprising the following steps:

   - determining a temperature dependence of the quartz crystal frequency offset against an external reference, resulting in quartz crystal parameters,
   - storing the quartz crystal parameters for further processing,
   - acquiring a temperature (3) measured by a temperature sensor (2),
   - calculating a deviation of the quartz crystal frequency offset (4) due to its temperature dependence and the measured temperature, and
   - generating compensation pulses (6) for the sleep timer (11) according to the deviation of the quartz crystal frequency offset d(T) as a function of the measured temperature T to adjust a counter value of the sleep timer

$$C_T = \left( f_0 + d_f \right) \cdot \Delta t + \begin{cases} d_c \cdot \Delta t & for\ d_f < 0 \\ -d_c \cdot \Delta t & for\ d_f \geq 0 \end{cases}$$

of the NB-IoT device, by compensating a counter bias

of the sleep timer by adding / subtracting compensation pulses $d_c \cdot \Delta t$ wherein the counter bias reaches, in a given interval, a value which is too low or too high, wherein $C_T$ is the compensated counter bias, $f_0$ is the nominal frequency of the sleep timer, $d_f$ is an overall uncertainty of the quartz frequency offset describing a momentary deviation at a given point in time, $\Delta t$ is a sampled interval, $d_c$ is a clock derived from an offset clock $f_T$ of the temperature-influenced quartz clock of the sleep timer, whereas the compensation pulses are performed in sleeping periods of the NB-IoT device according to the parabolic dependency on temperature of the quartz crystal frequency offset and acquired temperature, and wherein the temperature is acquired at fixed or adaptive temperature sampling intervals.

2. The method for digital temperature and drift compensation of a NB-IoT device according to claim 1, wherein the temperature sampling interval is selected based on up to four temperature ranges.

3. The method for digital temperature and drift compensation of a NB-IoT device according to one of the claims 1 or 2, wherein the temperature sampling interval is selected based on a temperature difference between a previous and a current sampling point.

4. The method for digital temperature and drift compensation of a NB-IoT device according to one of the former claims, wherein the temperature sampling interval is selected based on a predicted offset for compensation at a time of the previous temperature measurement and a calculated offset of the previous interval determined at a current measurement, multiplied with a length of the previous sampling interval.

5. The method for digital temperature and drift compensation of a NB-IoT device according to one of the former claims, wherein the temperature sampling interval is selected based on a temperature difference between a previous and a current sampling point and a predicted offset for compensation at a time of the previous temperature measurement and a calculated offset (4) of the previous interval determined at a current measurement, multiplied with a length of the previous sampling interval.

6. The method for digital temperature and drift compensation of a NB-IoT device according to one of the previous claims, wherein the external reference is a radio cell the NB-IoT is communicating with.

7. An apparatus for digital quartz temperature and drift compensation for a sleep timer (11) of a NarrowBand Internet of Things (NB-IoT) device (1) the apparatus being configured to perform the method according to claims 1 to 6, the apparatus comprising a temperature sensor (2) connected to a temperature acquisition block (3), an offset calculation block (4) connected to an internal storage block (5) for storing quartz crystal parameters for further processing and the temperature acquisition block (3) for acquiring a temperature (3) measured by a temperature sensor (2), the offset calculation block (4) is configured to calculate and determine an offset of a quartz frequency for the sleep timer (11) due to its temperature dependence based on measured temperature values by the temperature sensor (2), whereas the sleep timer (11) is connected to the apparatus for digital quartz temperature and drift compensation, the apparatus further comprising an adjustment generator (6) providing tuning pulses for the sleep timer (11) of the NB-IoT device (1) in a sleep phase according to the measured and determined temperature dependence of the frequency offset of the sleep timer (11), whereas the adjustment generator (6) is connected to the offset calculation block (4) and a controlling finite state machine (7) (FSM), and the FSM (7) controls the temperature acquisition block (3), the internal storage block (5) and the adjustment generator (6) .

8. The apparatus for digital quartz temperature and drift compensation for a sleep timer of a NarrowBand Internet of Things (NB-IoT) device (1) according to claim 7, wherein the adjustment generator (6) is a fractional divider.

9. The apparatus according to claims 7 or 8, wherein the temperature sensor (2) comprises a digital interface.

**Patentansprüche**

1. Verfahren zur digitalen Temperatur- und Driftkompensation eines Quarzkristalls mit parabolischer Abhängigkeit von der Temperatur ausgehend von seiner Nennfrequenz für einen Schlaf-Timer (11), der für eine Schmalband-IoT (NB-IoT, NarrowBand Internet of Things)-Vorrichtung verwendet wird, wobei das Verfahren die folgenden Schritte umfasst:

- Bestimmen einer Temperaturabhängigkeit des Quarzkristall-Frequenzversatzes gegenüber einer externen Referenz, woraus sich Parameter des Quarzkristalls ergeben,
- Speichern der Parameter des Quarzkristalls für die weitere Verarbeitung,
- Erfassen einer Temperatur (3), die von einem Temperatursensor (2) gemessen wird,
- Berechnen einer Abweichung des Quarzkristall-Frequenzversatzes (4) aufgrund seiner Temperaturabhängigkeit und der gemessenen Temperatur, und

- Erzeugen von Kompensationsimpulsen (6) für den Schlaf-Timer (11) gemäß der Abweichung des Quarzkristall-Frequenzversatzes d(T) in Abhängigkeit von der gemessenen Temperatur T, um einen Zählerwert des Schlaf-Timers der NB-IoT-Vorrichtung einzustellen, indem ein Zähler-Bias

$$C_T = (f_0 + d_f) \cdot \Delta t + \begin{cases} d_c \cdot \Delta t & \text{für } d_f < 0 \\ -d_c \cdot \Delta t & \text{für } d_f \geq 0 \end{cases}$$

des Schlaf-Timers durch Addieren/Subtrahieren von Kompensationsimpulsen $d_c \cdot \Delta t$ kompensiert wird, wobei der Zähler-Bias in einem gegebenen Intervall einen zu hohen oder zu niedrigen Wert erreicht, wobei $C_T$ der kompensierte Zähler-Bias ist, $f_0$ die Nennfrequenz des Schlaf-Timers ist, $d_f$ eine Gesamtunsicherheit des Quarz-Frequenzversatzes ist, die eine momentane Abweichung zu einem bestimmten Zeitpunkt beschreibt, $\Delta t$ ein Abtastintervall ist, $d_c$ ein Takt ist, der von einem Versatztakt $f_T$ des temperaturbeeinflussten Quarztaktes des Schlaf-Timers abgeleitet ist, wobei die Kompensationsimpulse in Schlafperioden der NB-IoT-Vorrichtung gemäß der parabolischen Temperaturabhängigkeit des Quarzkristall-Frequenzversatzes und der erfassten Temperatur durchgeführt werden, und wobei die Temperatur in festen oder adaptiven Temperaturabtastintervallen erfasst wird.

2. Verfahren zur digitalen Temperatur- und Driftkompensation einer NB-IoT-Vorrichtung gemäß Anspruch 1, wobei das Temperaturabtastintervall basierend auf bis zu vier Temperaturbereichen ausgewählt wird.

3. Verfahren zur digitalen Temperatur- und Driftkompensation einer NB-IoT-Vorrichtung gemäß einem der Ansprüche 1 oder 2, wobei das Temperaturabtastintervall basierend auf einer Temperaturdifferenz zwischen einem vorherigen und einem aktuellen Abtastpunkt ausgewählt wird.

4. Verfahren zur digitalen Temperatur- und Driftkompensation einer NB-IoT-Vorrichtung gemäß einem der vorstehenden Ansprüche, wobei das Temperaturabtastintervall basierend auf einem vorhergesagten Versatz für die Kompensation zu einem Zeitpunkt der vorherigen Temperaturmessung und einem berechneten Versatz des vorherigen Intervalls, der bei einer aktuellen Messung bestimmt wurde, multipliziert mit einer Länge des vorherigen Abtastintervalls ausgewählt wird.

5. Verfahren zur digitalen Temperatur- und Driftkompensation einer NB-IoT-Vorrichtung gemäß einem der vorstehenden Ansprüche, wobei das Temperaturabtastintervall basierend auf einer Temperaturdifferenz zwischen einem vorherigen und einem aktuellen Abtastpunkt und einem vorhergesagten Versatz für die Kompensation zu einem Zeitpunkt der vorherigen Temperaturmessung und einem berechneten Versatz (4) des vorherigen Intervalls, der bei einer aktuellen Messung bestimmt wurde, multipliziert mit einer Länge des vorherigen Abtastintervalls ausgewählt wird.

6. Verfahren zur digitalen Temperatur- und Driftkompensation einer NB-IoT-Vorrichtung gemäß einem der vorstehenden Ansprüche, wobei die externe Referenz eine Funkzelle ist, mit der die NB-IoT-Vorrichtung kommuniziert.

7. Einrichtung zur digitalen Temperatur- und Driftkompensation für einen Schlaf-Timer (11) einer Schmalband-IoT (NB-IoT, NarrowBand Internet of Things)-Vorrichtung (1), wobei die Einrichtung dafür ausgelegt ist, das Verfahren gemäß Anspruch 1 bis 6 durchzuführen, wobei die Einrichtung einen Temperatursensor (2), der mit einem Temperaturerfassungsblock (3) verbunden ist, einen Versatzberechnungsblock (4), der mit einem internen Speicherblock (5) zum Speichern von Parametern des Quarzkristalls für die weitere Verarbeitung verbunden ist, und den Temperaturerfassungsblock (3) zum Erfassen einer von einem Temperatursensor (2) gemessenen Temperatur (3) umfasst, wobei der Versatzberechnungsblock (4) dafür ausgelegt ist, einen Versatz einer Quarzfrequenz für den Schlaf-Timer (11) aufgrund seiner Temperaturabhängigkeit basierend auf durch den Temperatursensor (2) gemessenen Temperaturwerten zu berechnen und zu bestimmen, wobei der Schlaf-Timer (11) mit der Einrichtung zur digitalen Quarztemperatur- und Driftkompensation verbunden ist, die Einrichtung ferner einen Abgleichgenerator (6) umfasst, der gemäß der gemessenen und bestimmten Temperaturabhängigkeit des Frequenzversatzes des Schlaf-Timers (11) in einer Schlafphase Abstimmimpulse für den Schlaf-Timer (11) der NB-IoT-Vorrichtung (1) bereitstellt, wobei der Abgleichgenerator (6) mit dem Versatzberechnungsblock (4) und einem steuernden Zustandsautomaten (7) (FSM, Finite State Machine) verbunden ist und der FSM (7) den Temperaturerfassungsblock (3), den internen Speicherblock (5) und den Abgleichgenerator (6) steuert.

8. Einrichtung zur digitalen Temperatur- und Driftkompensation für einen Schlaf-Timer einer Schmalband-IoT (NB-IoT, NarrowBand Internet of Things)-Vorrichtung (1) gemäß Anspruch 7, wobei der Abgleichgenerator (6) ein fraktionaler Teiler ist.

9. Einrichtung gemäß Anspruch 7 oder 8, wobei der Temperatursensor (2) eine digitale Schnittstelle umfasst.

**Revendications**

1. Procédé de compensation de température et de dérive numérique d'un cristal de quartz avec une dépendance parabolique de la température par rapport à sa fréquence nominale pour un temporisateur de veille (11) utilisé pour un dispositif de l'Internet des objets à bande étroite (NB-IDO), le procédé comprenant les étapes suivantes :

   - la détermination d'une dépendance à la température du décalage de fréquence du cristal de quartz par rapport à une référence externe, obtenant ainsi des paramètres de cristal de quartz,
   - le stockage des paramètres du cristal de quartz pour un traitement ultérieur,
   - l'acquisition d'une température (3) mesurée par un capteur de température (2),
   - le calcul d'une déviation du décalage de fréquence du cristal de quartz (4) en raison de sa dépendance à la température et de la température mesurée, et
   - la génération d'impulsions de compensation (6) pour le temporisateur de veille (11) en fonction de la déviation du décalage de fréquence du cristal de quartz d(T) en fonction de la température mesurée T pour ajuster une valeur de compteur du temporisateur de veille du dispositif NB-IDO, en compensant une polarisation de compteur

$$C_T = (f_0 + d_f) \cdot \Delta t + \begin{cases} d_c \cdot \Delta t & pour\ d_f < 0 \\ -d_c \cdot \Delta t & pour\ d_f \geq 0 \end{cases}$$

   du temporisateur de veille en ajoutant/soustrayant des impulsions de compensation $d_c \cdot \Delta t$, la polarisation du compteur atteignant, dans un intervalle donné, une valeur trop faible ou trop élevée, $C_T$ étant la polarisation compensée du compteur, $f_0$ étant la fréquence nominale du temporisateur de veille, $d_f$ étant une incertitude globale du décalage de la fréquence du quartz décrivant une déviation momentanée à un moment donné, $\Delta t$ étant un intervalle échantillonné, $d_c$ étant une horloge dérivée d'une horloge de décalage $f_T$ de l'horloge à quartz influencée par la température du temporisateur de veille, en considérant que les impulsions de compensation sont effectuées dans les périodes de veille du dispositif NB-IDO en fonction de la dépendance parabolique à la température du décalage de fréquence du quartz et de la température acquise, et la température étant acquise à des intervalles d'échantillonnage de température fixes ou adaptatifs.

2. Procédé de compensation de température et de dérive numérique d'un dispositif NB-IDO selon la revendication 1, l'intervalle d'échantillonnage de température étant sélectionné sur la base de jusqu'à quatre plages de température.

3. Procédé de compensation de température et de dérive numérique d'un dispositif NB-IDO selon l'une des revendications 1 ou 2, l'intervalle d'échantillonnage de température étant sélectionné sur la base d'une différence de température entre un point d'échantillonnage précédent et un point d'échantillonnage actuel.

4. Procédé de compensation de température et de dérive numérique d'un dispositif NB-IDO selon l'une des revendications précédentes, l'intervalle d'échantillonnage de température étant sélectionné sur la base d'un décalage prédit pour la compensation à un moment de la mesure de température précédente et d'un décalage calculé de l'intervalle précédent déterminé à une mesure actuelle, multiplié par une longueur de l'intervalle d'échantillonnage précédent.

5. Procédé de compensation de température et de dérive numérique d'un dispositif NB-IDO selon l'une des revendications précédentes, l'intervalle d'échantillonnage de température étant sélectionné sur la base d'une différence de température entre un point d'échantillonnage précédent et un point d'échantillonnage actuel, et d'un décalage prédit pour la compensation à un moment de la mesure de température précédente et d'un décalage calculé (4) de l'intervalle précédent déterminé lors d'une mesure actuelle, multiplié par une longueur de l'intervalle d'échantillonnage précédent.

6. Procédé de compensation de température et de dérive numérique d'un dispositif NB-IDO selon l'une des revendications précédentes, la référence externe étant une cellule radio avec laquelle le NB-IDO communique.

7. Appareil de compensation de température et de dérive numérique d'un quartz d'une horloge de veille (11) d'un dispositif (1) de l'Internet des objets à bande étroite (NB-IDO), l'appareil étant configuré pour effectuer le procédé selon les revendications 1 à 6, l'appareil comprenant un capteur de température (2) connecté à un bloc d'acquisition de température (3), un bloc de calcul de décalage (4) connecté à un bloc de stockage interne (5) pour stocker des paramètres de cristal de quartz pour un traitement ultérieur et le bloc d'acquisition de température (3) pour acquérir une température (3) mesurée par un capteur de température (2), le bloc de calcul de décalage (4) étant configuré pour calculer et déterminer un décalage d'une fréquence de quartz pour le temporisateur de veille (11) en raison de sa dépendance à la température sur la base des valeurs de température mesurées par le capteur de température (2), tandis que le temporisateur de veille (11) est connecté à l'appareil pour une compensation de température et de dérive numérique d'un quartz, l'appareil comprenant en outre un générateur de réglage (6) fournissant des impulsions de réglage pour le temporisateur de veille (11) du dispositif NB-IDO (1) dans une phase de veille en fonction de la dépendance à la température mesurée et déterminée du décalage de fréquence du temporisateur de veille (11), tandis que le générateur d'ajustement (6) est connecté au bloc de calcul de décalage (4) et à une machine à états finis de commande (7) (FSM), et la FSM (7) commande le bloc d'acquisition de température (3) le bloc de stockage interne (5) et le générateur d'ajustement (6).

8. Appareil de compensation de température et de dérive numérique de quartz pour un temporisateur de veille d'un dispositif (1) de l'Internet des objets à bande étroite (NB-IDO) selon la revendication 7, le générateur d'ajustement (6) étant un diviseur fractionnaire.

9. Appareil selon la revendication 7 ou 8, le capteur de température (2) comprenant une interface numérique.

Fig. 1

$\Delta f / f_0$

$T$

temp. offset $d_f(T)$

temp. coefficient $c_T$

Fig. 2

$\Delta f / f_0$

turnover temp. $T_0$

$T$

temp. offset $d_f(T)$

Fig. 3

Fig. 4

Fig. 5

comp.pulse

Fig. 6

Fig. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6473607 B1
- WO 2010002330 A1
- US 4922212 A